# EUROPEAN PATENT APPLICATION

(11) **EP 4 841 493 A1**
(43) Date of publication of application: **18.11.2026**
(21) Application number: 25000083.3
(22) Date of filing: 18.08.2025
(51) Int. Cl.: G06F 30/13, G06Q 10/06, G06Q 10/0635, G06Q 50/08, G06Q 50/26, E04H 17/02

(54) **COMPUTER-IMPLEMENTED METHOD AND SYSTEM FOR PLANNING A SECURITY INFRASTRUCTURE, COMPUTER PROGRAM PRODUCT AND COMPUTER-READABLE STORAGE MEDIUM**

(30) Priority: 14.05.2025 EP 25000050
(71) Applicant: Mobile Defence Solutions GbR vertreten durch Florian Bock und Fabian Frank, 89299 Unterroth (DE)
(72) Inventor: Bock, Florian, 87727 Babenhausen (DE); Frank, Fabian, 87727 Babenhausen (DE)

(57) **Abstract**

The invention relates to a computer-implemented method for planning a security infrastructure for at least a sub-area (4) of a property (2) is described, the method comprising the steps of:
a) Providing geographical information data (14) about at least one sub-area (4) of the property (2);
b) Creating a digitally mapped processing surface (16) of the at least one sub-area (4) of the property (2) based on the geographical information data (14) provided in step a);
c) Selecting and arranging digital security elements (6) on the digitally mapped processing surface (16) to create a digital image (18) of the security infrastructure of the at least one sub-area (4) of the property (2);
d) Creating a security protocol (20) based on the digital image (18) of the security infrastructure created in step c), wherein the security protocol (20) comprises at least one piece of information about the number of security elements (6) and/or the type of security elements (6) and/or the position of the security elements (6) on the at least one sub-area (4) of the property (2).

## Description

The invention relates to a novel approach to planning a security infrastructure for at least a sub-area of a property.

Existing safety planning processes and/or systems for securing properties, such as construction sites and/or concert grounds, do not have the capability to support, for example, real-time geospatial mapping, Al-powered safety assessments and/or automated generation of rule-compliant documentation.

Instead, current methods rely heavily on manual planning, calculations and assessments as well as documentation, which can be error-prone, outdated and inefficient. This makes safety planning and documentation time-consuming, suboptimal and possibly even neglected due to the effort involved.

Therefore, it is an object of the present invention to at least partially solve the problems described with reference to the prior art. In particular, the invention is based on the object of providing a computer-implemented method and a system, with which the planning of securing at least part of a property is simplified and improved.

The problem is solved by the invention with the features according to the independent claims. Preferred embodiments, further embodiments and variants are subject matter of the dependent claims as well as the description and in particular the description of the figures. It should be noted that the person skilled in the art can combine the individual features with one another in a technologically meaningful way and thus can arrive at further embodiments of the invention.

A computer-implemented method for planning a security infrastructure for at least a sub-area of a property is described, the method comprising the steps of:
a) Providing geographical information data about at least one sub-area of the pro-perty;
b) Creating a digitally mapped processing surface of the at least one sub-area of the property based on the geographical information data provided in step a);
c) Selecting and arranging digital security elements on the digitally mapped processing surface to create a digital image of the security infrastructure of the at least one sub-area of the property;
d) creating a security protocol based on the digital image of the security infrastructure created in step c), wherein the security protocol comprises at least one piece of information about the number of security elements and/or the type of security elements and/or the position of the security elements on the at least one sub-area of the property.

The digitally mapped processing surface is therefore preferably a digital version or a digital and editable image of at least one sub-area of the property to be secured. Alternatively or additionally, the entire property can also be used for protection. For the purposes of this application, the term "property" can be understood to mean, for example, a construction site, a depot, a concert site, a photovoltaic park or generally a geographically delimitable area that is worth securing.

Furthermore, the digitally mapped processing surface can preferably be a user interface via which a user of the method can select and arrange the digital security elements, for example in step c) of the method. For example, but not by way of limitation, the digital security elements are arranged by drag-and-drop.

The specific advantages of this process arise both from a technical point of view and in terms of practical use compared to the manual state of the art.

First of all, step a), the provision of geographical information data, offers the advantage that planning can be carried out on an objective, digital and georeferenced database. Current geographical information data is preferably used here. This enables the exact location of at least one sub-area or the entire property to be secured and the subsequent positioning of security-relevant elements. Planning errors resulting from inaccurate or outdated data can also be prevented.

The subsequent step b), the creation of a digitally mapped editing interface, creates a visual, interactive planning environment. This not only improves usability and clarity for the user, but also allows dynamic adaptation to different terrain shapes and usage scenarios. The digital and visual user interface makes the entire planning process considerably more efficient and less error-prone.

Step c), the selection and arrangement of digital security elements, offers the main advantage of simulation. For example, the user can run through and optimize various security scenarios even before physical measures are taken. The process can also include validation functions that check minimum distances, escape route clearance or lines of sight, for example - which increases the quality and effectiveness of safety planning.

For the purposes of this application, the term "digital security element" can be understood to mean a digital twin of a security element that is later physically constructed "in the field". Non-limiting examples of such security elements are (construction) fences, camera towers, security gates, access control systems, turnstiles, doors or barriers. In particular, a security element configured as a fence is a mobile fence, as shown in DE 20 2016 100 430 U1, to which reference is made in full in this respect. Furthermore, the security element configured as a fence can also be a mobile fence which comprises a sensor unit on or in a holder and/or on or in a fence post and/or on or in a fence element for detecting at least one status information and/or at least one environmental information of the mobile fence.

With step d), the creation of a security protocol, another significant advantage is realized. Namely the automatic, structured and digital documentation of the planning. This not only ensures traceability, but also for example supports compliance with legal and official requirements. Particularly in safety-critical areas such as major events, construction sites or industrial plants, audit-proof logging is essential - this step ensures it systematically.

Furthermore, step d) can also involve the (automated) creation of bills of materials (BoM) for the physically required security elements. This can significantly simplify the ordering process in particular. For example, once the planning has been completed and the security protocol has been created, a created bill of materials can be sent directly to a lessor and/or dealer of such security elements, including details of the name and delivery address, in order to optimize supply chains, times and ordering routes.

The security protocol can be exported digitally, for example in a standard format, in particular PDF, CAD or DXF format, so that it can be opened and, if necessary, further processed and/or supplemented by almost all devices.

In summary, the process leads to a considerable increase in efficiency, improved planning quality, legally compliant and audit-proof documentation and an increase in operational implementation security. It thus represents a significant further development compared to the state of the art, which is largely based on manual, paper-based and fragmented processes,

For example, the method according to the invention can also be designed or developed as an API-based integration for other software solutions. Furthermore, the method can be carried out both software-based on a stationary or portable computer (laptop or notebook). Alternatively or additionally, however, the method can also be executed on a portable smart device, e.g. a tablet or a smartphone.

According to one embodiment, the security protocol created in step d) is used as a basis for establishing the security infrastructure for the at least one sub-area of the property.

This step allows the direct implementation of the planned measures based on the security protocol. The security protocol preferably serves as a kind of blueprint or construction plan with all the information about the exact placement of certain security elements. The advantage here lies in the clear instructions for action. Digital planning is converted into real, operational safeguarding, which avoids media disruptions, saves time and reduces coordination errors. At the same time, this step facilitates communication with the service providers involved, as standardized, digitally readable information can be used.

Furthermore, it may be advantageous if the geographical information data includes at least one of the following pieces of information:
- Dimensions of at least one sub-area of the property; and/or
- Type of use of at least one sub-area of the property; and/or
- Special infrastructure on at least one sub-area of the property.

The inclusion of extended geographical information data, such as dimensions of at least one sub-area of the property, the type of use and special infrastructure, offers several decisive advantages for the quality, precision and application flexibility of security planning.

If the geographical information data includes the dimensions of the sub-area, this enables exact scaling and positioning of the security elements in the digital processing surface. For example, this indicates the size of the sub-area and/or the property and/or the shape of the floor plan. This allows safety distances, fields of vision, restricted zones or escape and rescue routes to be precisely planned and automatically checked. It also creates the basis for realistic simulations, for example to determine the required number of safety devices or to avoid over- or under-protection.

The type of use of at least one sub-area of the property provides a contextual framework for security planning. Different types of use - such as a construction site, a festival site, a storage area or an area accessible to the public - sometimes require different specific protective measures, legal requirements and/or risk assessments. The integration of this information allows the method to make rule-based suggestions as to which safety elements are required or particularly suitable. This leads to situation-adapted, intelligent planning that is both efficient and compliant.

Finally, the consideration of special infrastructure, such as expensive construction machinery and/or goods, power lines, underground cables, access roads, fencing, water extraction points, special structures or escape and rescue routes, offers the advantage that security measures can be planned not only effectively, but also in a practical and conflict-free manner. The method can avoid potential collisions or unauthorized placements and at the same time ensure that existing infrastructure is sensibly integrated into the security considerations - for example, by specifically securing particularly sensitive or critical areas.

Overall, this additional information increases planning accuracy, enables automated control checks and supports a context-sensitive, optimized design of the backup infrastructure. This not only makes the method more robust, but also considerably more adaptable to different application scenarios and requirements.

According to a further embodiment of the invention, the geographical information data is provided in step a) from one of the following information sources:
- Satellite images and/or satellite maps; and/or
- Road maps; and/or
- Drone images; and/or
- Technical drawings, in particular CAD construction plans; and/or
- GIS-data.

The ability to provide geographical information data from various sources such as satellite images, road maps, drone images, technical drawings, in particular CAD construction plans, or GIS data, offers a considerable advantage in terms of the flexibility, accuracy and timeliness of the terrain information on which security planning is based. Each of these data sources has specific strengths that can be used or combined in a targeted manner, depending on the application.

Satellite images and/or satellite maps provide a large-scale, up-to-date and detailed representation of at least one sub-area of the property. They are particularly suitable for an initial overview and provide a good basis for recording topography, vegetation, buildings and/or access routes. The main advantage lies in the area-wide availability and the possibility of including remote or inaccessible areas in the planning.

Road maps can supplement this data in order to "visualize" structural and infrastructural information such as paths, access roads, traffic routing or public facilities. This is particularly relevant for planning access routes for emergency services, evacuation routes or access controls. Road maps are usually vectorized and can therefore be easily automated and filtered.

Drone images offer a highly up-to-date, detailed and flexible perspective view of the property. They are particularly suitable for recording temporary changes - for example in the construction site context - or for planning from a bird's eye view. The great advantage lies in the up-to-dateness and accuracy, which allows realistic planning even with dynamic or complex terrain shapes.

Technical drawings, such as (CAD) construction plans or terrain sections, offer a structured, true-to-scale and standardized representation of relevant building elements, terrain structures and/or infrastructure. They provide a particularly precise and legally binding basis for the placement of safety-relevant measures - for example, for integration into existing buildings or for compliance with safety distances in accordance with DIN or VDE specifications.

GIS data (geoinformation systems) are particularly powerful, as they can comprise semantic information in addition to the geometric representation, such as terrain heights, zoning, usage classes or risk assessments. The advantage here lies in the ability to automatically carry out complex analyses, e.g. for hazard assessment, land use or risk zone identification.

The combined or alternative use of the above-mentioned data sources makes the method extremely adaptable, as it can rely on different sources of information depending on availability, accuracy requirements or the planning situation. This not only improves the robustness and accuracy of the planning, but also the scalability of the method - from a rough site plan to finely detailed deployment planning and/or positioning of the security elements. This represents a significant technical advance over rigid, single-source-based planning procedures.

It can also be advantageous if the following sub-steps are carried out before or during step c):
- Calculating partial areas and/or the total area of the at least one sub-area of the property; and/or
- Calculating a three-dimensional terrain model and/or a three-dimensional building model of buildings located on the at least one sub-area of the property; and/or
- Calculating the required lengths of the safety elements, in particular fence lengths; and/or
- Calculation of illuminated or illuminable areas of the at least one sub-area of the property; and/or
- Calculating blind spots of surveillance cameras on at least one sub-area of the property.

Carrying out the aforementioned sub-steps before or during step c) - i.e. before or during the selection and arrangement of digital security elements - offers a whole range of technical and practical advantages that contribute directly to the efficiency, accuracy and quality of security planning. In particular, these calculation steps enable data-driven, automated support of the decision-making processes during planning and thus create a significant improvement over manual, experience-based planning.

Calculating partial areas and/or the total area of the relevant site area creates a precise metric basis for planning. At the touch of a button, for example, it is possible to determine which areas need to be secured, how large individual zones are and whether certain safety requirements (e.g. escape and rescue route widths, spacing requirements) are met. At the same time, it supports the quantity calculation of the required safety elements and thus also the cost estimation and resource planning.

The calculation of a three-dimensional terrain model offers the advantage that height differences, slopes, visual obstructions or infrastructural barriers can be realistically mapped and included in the planning. This is essential for effective protection, especially when topographical conditions have an influence on lines of sight, fence layout or light distribution. The 3D building model also enables the precise positioning of security-relevant components in or around a building - e.g. cameras on façades, lighting on roof edges or access controls at real entrances.

Calculating the required lengths of the safety elements, especially fence lengths, automates the otherwise manual and error-prone quantity determination process. This not only speeds up planning considerably, but also contributes to material optimization and budget accuracy - especially for large or complex terrain sections.

The calculation of illuminated or illuminable areas on at least one sub-area of the property makes a significant contribution to safety effectiveness, as it optimizes the planning of lighting measures. For example, it is possible to automatically determine whether an area is fully illuminated, whether glare occurs or whether additional light sources are required. This not only improves technical safety, but also supports regulatory requirements, such as those arising from occupational health and safety or event safety regulations.

Calculating the blind spots of surveillance cameras is a highly relevant aspect of seamless surveillance. This makes it possible to automatically detect whether and where surveillance deficits exist so that cameras can be optimally readjusted or supplemented. This not only makes planning safer, but also makes it objectively verifiable and documentable.

In summary, these calculation steps lead to a significantly increased planning depth, technical penetration and automation of the safety infrastructure. They make a significant contribution to making the method more intelligent, application-robust and economical - both for simple properties and for highly complex, dynamic environments.

In one embodiment, step d) further includes a risk analysis to assess security vulnerabilities and/or hazards, with the result of the risk analysis forming part of the safeguarding protocol.

The integration of a risk analysis in step d) - i.e. as part of the creation of the security protocol - represents a particularly important advantage, as it adds a systematic strategic security assessment level to the method. While the previous steps are primarily aimed at the technical and geographical design of the security infrastructure, the risk analysis includes a qualitative and quantitative assessment of potential dangers, which is crucial for effective and responsible protection.

A key advantage lies in the objective identification and prioritization of security gaps. The risk analysis can be used to automatically or semi-automatically identify which areas of at least one sub-area of the property are particularly at risk - for example, due to their use (e.g. storage of valuable goods, high passenger traffic), their accessibility, structural vulnerabilities or inadequate technical protection. This allows the method to specifically point out these weak points and recommend or even prescribe appropriate measures.

The fact that the result of the risk analysis is part of the security protocol also brings with it a considerable documentary and legal advantage. The safety planning is not only technically recorded, but also evaluated in terms of its risk and hazard potential and comprehensibly justified. This increases the transparency and legal certainty of the planning - especially vis-à-vis authorities, insurers or other stakeholders. In the event of an incident, it can be traced whether risks have been identified and addressed appropriately.

Another practical advantage is the ability to create a tailored, prioritized security concept based on the risk analysis, which targets resources where they will bring the greatest benefit. This leads to increased cost-effectiveness and efficiency of the measures without compromising on effectiveness. Furthermore, the safety concept can also be used to create rule-compliant documentation in writing, thus demonstrably ensuring that legal requirements are met.

The risk analysis also allows dynamic adaptation. If risk factors change (e.g. new uses of the property), the system can update the planning and react to new hazards.

In summary, the integration of a risk analysis leads to strategically sound, adaptive and legally robust safety planning. It clearly elevates the method beyond purely structural or geographical approaches and turns it into an intelligent planning tool that holistically integrates both technical and risk-based aspects.

It can also be advantageous if, according to a preferred further embodiment, the risk analysis is carried out based on predetermined security requirements and/or based on predetermined simulations of threat scenarios.

Performing a risk analysis based on predetermined security requirements and/or simulations of threat scenarios offers significant advantages for security planning and assessment. This approach enables a targeted and realistic analysis of potential threats and risks, which significantly improves both the quality of planning and the efficiency and effectiveness of the security measures implemented.

A key advantage of risk analysis based on predefined safety requirements is conformity with applicable regulations and standards as well as official requirements. Safety requirements are often based on legal or normative specifications, such as work or event safety regulations, and guarantee that all safety-relevant aspects are taken into account in accordance with the prescribed minimum requirements. This ensures that the planning is both legally and technically correct and that there are no critical safety gaps that could lead to liability risks. In addition, the precise focus on these requirements enables targeted and resource-saving planning, as the measures correspond exactly to the required standards and are not oversized or inefficient.

The simulation of threat scenarios constitutes an additional significant advantage. It enables a realistic and dynamic risk assessment by incorporating specific hazards, such as natural disasters, terrorist threats, or other security-relevant incidents. These scenarios preferably serve as a practice-oriented basis for evaluating the performance of the security infrastructure under actual threat conditions and for verifying whether the planned measures are effective in operational contexts. A further advantage lies in the ability to test various response strategies through simulation, including evacuation protocols and the effectiveness of surveillance measures. This allows for a preemptive evaluation of whether existing security provisions are adequate or whether modifications are required to ensure a robust and resilient security infrastructure..

In addition, scenario-based analysis contributes to improved predictive accuracy by identifying potential risks before they materialize. The capability to simulate various threats enables the implementation of preventive measures in advance, thereby minimizing the impact of an actual incident. This approach particularly supports efficient resource allocation, as security measures can be reinforced where they are most urgently required based on the realistic threat profiles revealed through simulation.

Summarized, the integration of risk analyses based on predefined security requirements and threat scenarios provides a strategically sound and practice-oriented approach that optimizes both the legal compliance and operational efficiency of security planning. It ensures that the security measures not only meet regulatory requirements but are also aligned with actual hazards and potential emergencies, resulting in overall safer and future-proof planning.

It may further be advantageous if the risk analysis is carried out with respect to the digital security elements selected and arranged in step c).

This embodiment offers advantages in terms of the precision and effectiveness of security planning. By aligning the risk analysis directly with the specific security measures considered in the planning, a targeted and reality-based security assessment can be performed. This enables a well-founded evaluation of the effectiveness and efficiency of the planned security infrastructure.

A key advantage of this approach is that the risk analysis can verify the correctness and suitability of the selected security elements. Since specific digital security elements, such as fences, cameras, lighting systems, or access controls, are placed and arranged on the digital map in step c), the subsequent risk analysis enables a realistic assessment of whether these elements address the existing risks. For example, the analysis could determine that a camera at a particular location would be ineffective due to blind spots or obstructions, or that a fence arrangement on a slope may not provide the desired security due to the topography. This precise adjustment ensures that the security infrastructure functions in reality as it was planned on the digital surface.

Furthermore, a risk analysis based on the selected security elements enables optimal placement and sizing of the elements. It ensures that the correct elements are installed at the appropriate locations on the site. This leads to a more efficient use of resources, as no security measures are unnecessarily applied in non-critical areas, while key hazard zones are sufficiently secured. Such detailed and tailored planning reduces the risk of security gaps and ensures maximum effectiveness of the implemented measures.

Another advantage is that this risk analysis, focused on the specific security measures, also allows for the evaluation of the interaction between the elements. It can be assessed whether the various security elements - such as lighting, cameras, and fences - work together optimally to ensure comprehensive security coverage. Such integration ensures that no redundant or unnecessary elements are implemented, which could increase costs or complicate operation. Potential weaknesses in the interaction between the different security elements can also be identified and adjusted early on.

Finally, performing the risk analysis based on the digital security elements defined in step c) results in increased legal certainty and traceability. Since the risk analysis is directly based on the specifically planned infrastructure, a detailed, traceable documentation can be created, for example, in the form of the previously mentioned security protocol, outlining the implemented security measures. This documentation can serve as evidence in practice that the security provisions comply with legal requirements and that the risks are minimized in a comprehensive and reliable manner.

In summary, the risk analysis concerning the selected and arranged digital security elements offers the advantage of higher precision and efficiency in planning. It ensures that the chosen security measures align with the specific requirements and risks of the site and are optimally deployed to create a comprehensive, effective, and cost-efficient security infrastructure.

In one embodiment, step c) is repeated if the risk analysis performed in step d) determines that the digital security elements selected and arranged in step c) are insufficient, particularly containing security gaps and/or potential hazards.

The repetition of step c) when the risk analysis conducted in step d) reveals that the selected and arranged digital security elements are inadequate offers significant benefits for the security and efficiency of the entire planning process. This iterative approach enables continuous optimization of the security infrastructure and ensures that the security concept remains both flexible and adaptable to the identified risks and vulnerabilities.

A key advantage of this iterative process is real-time error correction. When the risk analysis identifies security gaps or potential hazards, repeating step c) enables quick and targeted adjustments to the security elements. This ensures that all threats identified in the risk analysis can be immediately addressed. For example, as mentioned previously, the risk analysis may reveal that a particular security object, such as a surveillance camera, does not provide the expected coverage due to a blind spot or insufficient lighting in an area. Repeating the planning in step c) allows this issue to be directly resolved, for instance, by changing the camera position or adding additional light sources.

Another advantage of this approach is that it allows for a dynamic adjustment of the security infrastructure. Security requirements may change throughout the planning process, especially when new risks or threats are identified. By enabling the planning process to be repeated multiple times, security measures can be continuously adapted to real-world conditions and changes. This flexibility is particularly beneficial in dynamic or rapidly changing environments, such as construction sites, events, or emergency situations.

Moreover, the repetition of the planning phase in step c) ensures that the quality and effectiveness of the security measures are continuously improved. Since the risk analysis not only identifies weaknesses but also highlights potential areas for improvement, the security elements can be specifically optimized and tested for their effectiveness. This continuous improvement process leads to a more effective, adaptable security strategy that is both cost-efficient and optimized for security.

Another practical advantage is the minimization of iteration cycles. By quickly addressing identified security gaps, unnecessary repeated mistakes or redundant changes can be avoided. The process enables faster error correction and adjustment of the planning, ultimately leading to a quicker and more accurate implementation of the security infrastructure.

Additionally, the iterative review and adjustment in step c) ensures that the planning not only functions from a technical perspective but also complies with legal and regulatory requirements. If weaknesses are identified after the risk analysis that may violate regulations or fail to meet security standards, these can be quickly corrected, ensuring that the final security infrastructure meets all applicable regulations.

According to a preferred embodiment, a neural network is used at least for step b) and/or step c) and/or step d) and/or for the substeps before or during step c).

The use of a neural network offers significant advantages in terms of efficiency, precision, and automation. In step b), during the creation of the digitally mapped editing interface, a neural network can, for example, assist in automatically extracting geographic features from large datasets such as satellite images or drone footage. This leads to a faster and more accurate mapping of at least a portion of the site, without the need for manual intervention. The neural network specifically identifies and processes relevant information, such as terrain structures, existing infrastructures, or access routes, thereby creating a detailed and error-free digital map.

In step c), the selection and arrangement of digital security elements, a neural network can also provide significant added value. It can recognize patterns from historical data and existing security analyses and, based on this, propose the optimal locations for security elements such as fences, cameras, or lighting systems. A neural network can not only consider the current conditions but also potential security gaps by automatically recommending the best placement of elements to close these gaps. This intelligent placement ensures a more efficient and effective security infrastructure, as the neural network takes into account and optimizes the interactions between the various elements, such as cameras and lighting.

In step d), particularly in the risk analysis, the neural network can be especially valuable, as it is capable of recognizing patterns and correlations that would be difficult for humans to discern. It can analyze large datasets, thereby uncovering unknown hazards or weaknesses in the security planning. For example, it could learn from historical incidents or simulations of threat scenarios and generate precise risk forecasts. This enables a deeper and more accurate assessment of security measures and helps identify risks early, before they materialize. For instance, it could predict the risk of flooding based on historical weather data and suggest corresponding security measures in response.

Even in the aforementioned substeps before or during step c), the neural network provides benefits. When calculating areas, building models, or fence lengths, it can perform the calculations efficiently and accurately based on the geographic data provided in the previous step. Additionally, the neural network can assist in calculating illuminated areas or analyzing blind spots of cameras, helping to determine the optimal locations for security measures and ensuring that no areas are overlooked. It also takes into account changes in the environment, such as alterations in the terrain or changes in the use of the area, and adjusts the planning accordingly.

In summary, the use of a neural network in the various steps of security planning results in significantly higher efficiency, precision, and flexibility. The neural network enables the processing of large datasets, recognizes patterns, and automatically optimizes, allowing the security infrastructure to be dynamically adapted to changing requirements and risks. It ensures a smarter and more effective planning process that not only addresses current needs but also considers future threats.

According to an embodiment, step a) and/or step b) and/or step c) and/or step d) are sub-steps in the creation of a reference model for the machine learning of the neural network, in order to select the number and/or type and/or position of the digital security elements on the at least a sub-area of the property.

The advantage of this extension lies in the ability to enhance the adaptability and efficiency of the entire planning process. A reference model serves as a foundation to continuously train the neural network and improve its learning ability, leading to an increasingly precise selection and placement of the digital security elements.

In step a), when geographic information data is provided, the neural network can, for example, learn from historical or existing data how different geographic features correlate with . the need for security elements. For instance, the model can learn how specific types of terrain or land uses are more likely to require certain security measures, such as increased fence lengths in particular areas or enhanced lighting in areas with limited visibility. By creating a reference model for these data, the neural network can automatically learn which geographic features correlate with specific security needs, providing the foundation for optimized planning.

In step b), the creation of the digitally mapped editing interface, the reference model can assist the neural network in predicting the precise positioning and arrangement of security elements on the map. Specifically, when the neural network is trained with a comprehensive dataset covering terrain features, existing infrastructure, and security requirements, it can help create the map not only based on the current geodata but also on historical or simulation-based security needs. As a result, the model can better understand the terrain and place optimized security elements in the relevant areas.

Step c) of the method, in which digital security elements are selected and arranged, can also benefit from a reference model. Here, machine learning based on experiences and data from previous security planning can indicate which elements are most effective at specific locations to minimize certain threat scenarios. The reference model helps the neural network become increasingly precise by addressing realistic conditions and actual security needs. For example, the neural network can automatically suggest the optimal placement of security measures based on the data and patterns of the model. This automation improves planning efficiency, reduces human error, and simultaneously optimizes the security value of the infrastructure.

Even in step d), the risk analysis, the reference model can play a central role. Through machine learning and based on the trained model, the neural network can conduct a more accurate risk analysis by identifying potential security gaps and/or danger zones that might have been overlooked without a trained model. The reference model can learn, through continuous training on new data and the simulation of threat scenarios, which security gaps are most likely and where additional security measures are required.

Overall, the reference model enables the neural network to ensure continuous improvement in the selection and placement of digital security elements. Through the ongoing learning process, the method becomes smarter and more precise, as it constantly responds to new data and learned patterns. This machine learning approach leads to a more dynamic and adaptable security planning process, which can better respond to changing environments and new threats. Additionally, by training the neural network on a reference model, the automation and efficiency of the entire method are increased, saving time and reducing the need for manual interventions.

A system for planning a security infrastructure for at least a sub-area of a property is also to be described, wherein the system includes:
- a user interface module for performing steps a) and/or b) and/or c);
- an evaluation module for performing step d); and
- an output module for outputting the security protocol created in step d).

In an embodiment, the system further comprises:
- a simulation module for simulating threat scenarios and/or security risks; and/or
- a conformity module for creating a security documentation, wherein the security documentation includes at least the security protocol created in step d).

In particular, the conformity module is an alternative or complementary module that offers advantages in terms of efficiency and accuracy when documenting security measures. The conformity module preferably ensures that the security documentation, which includes the security protocol created in step d), complies with legal, normative, and organizational requirements, and that all mandated standards and regulations are adhered to.

Also to be described is a computer program product comprising instructions which, when the program is executed by a computer, cause the computer to carry out the described method.

Further to be described is a computer-readable storage medium comprising instructions which, when executed by a computer, cause the computer to carry out the described method.

The invention and its technical environment are further explained below with reference to the figures. The figures show preferred embodiments, to which the invention is not limited. It should particularly be noted that the figures and, in particular, the size ratios depicted in the figures are for illustrative purposes only. The following are shown:
- Fig. 1: a schematically depicted top view of a property to be secured, with security elements already arranged; and
- Fig. 2:: a schematically depicted block diagram to illustrate the method.

In the figures, identical or functionally equivalent components are always depicted with the same reference signs.

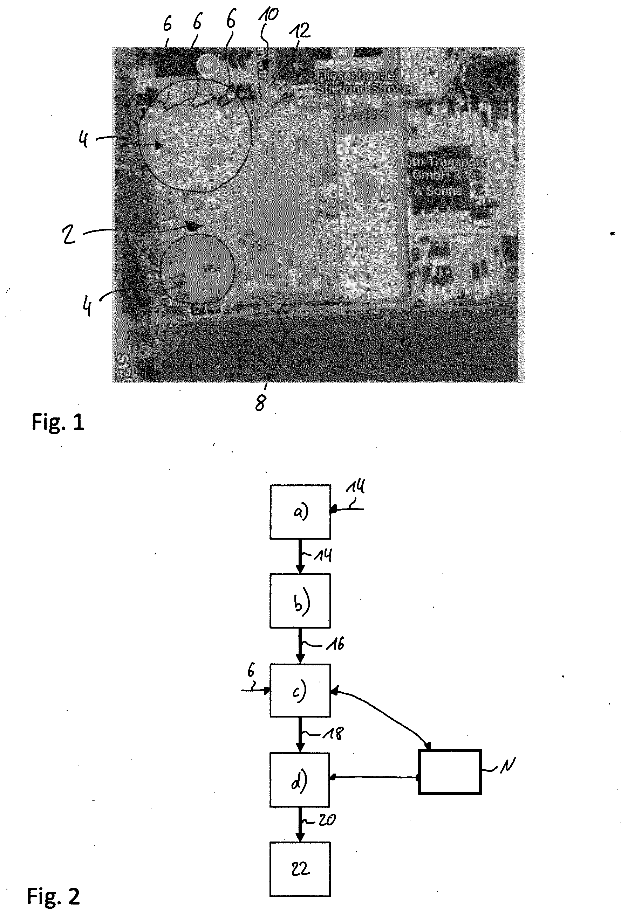

Fig. 1 shows a top view of a property 2 to be secured from a bird's-eye perspective. The property 2 is bounded by a solid line.

As shown, the property 2 to be secured includes two sub-areas 4, which are simplified in Fig. 1 as circular areas. These sub-areas 4 require special security in the present example, as they contain, for instance, expensive equipment or other particularly sensitive infrastructure.

Furthermore, the property 2 to be secured already includes three arranged security elements 6. The security elements 6, designed as fence elements, are positioned - in the plane of the image - in the top left corner of the property 2 along the previously mentioned boundary line 8 of the property, as indicated by a line.

Additionally, an access control unit 12 is installed in an entrance area 10 of the property 2 to monitor vehicles entering or leaving the property 2 and/or people entering or leaving the property 2.

To further secure the two aforementioned sub-areas 4 separately, additional - not shown - security elements 6 may be provided.

The precise planning of the number and/or type and/or position of the necessary security elements 6, depending on the required level of security, can, for example, be carried out using the method described in the invention.

The method according to the invention is now explained with reference to the flowchart shown in Fig. 2.

In a first step a), geographical information data 14 about at least one sub-area 4 of the property 2 is provided. Preferably, the geographical information data 14 is provided for the entire property 2.

The geographical information data 14 may, for example, be a satellite image, such as the one shown in Fig. 1, which depicts the property 2 to be secured. Alternatively or additionally, the geographical information data 14 may come from the following, non-limiting sources:
- Road maps; and/or
- Drone images; and/or
- Technical drawings; and/or
- GIS-data.

In the subsequent step b) of the method according to the invention, a digitally mapped processing surface 16 of the at least one sub-area 4 of the property 2 is created based on the geographical information data 14 provided in step a).

The creation of the digitally mapped processing surface 16 is thus based on the geographical information data 14, which may have been processed.

Subsequently, in step c), digital security elements 6 are selected and arranged on the digitally mapped processing surface 16 to create a digital image 18 of the security infrastructure for the at least one sub-area 4 of the property 2. This step can alternatively or additionally be supported or fully carried out by a neural network N, which suggests positioning the security elements 6 adapted to a desired level of security and/or requirements. Furthermore, the arrangement of the digital security elements 6 carried out in step c) can also be used for training the neural network N.

In the subsequent step d) of the method, a security protocol 20 is created based on the digital representation of the security infrastructure created in step c), wherein the security protocol 20 contains at least information about the number of security elements 6 and/or the type of security elements 6 and/or the position of the security elements 6 on the at least one sub-area 4 of the property 2. This step can alternatively or additionally be supported or fully carried out by the neural network N. Furthermore, alternatively or additionally, the security protocol 20 created in step d) can also be used for machine learning of the neural network N.

Preferably, the security protocol 20 created in step d) is then used as a basis for the implementation 22 of the security infrastructure of the at least one sub-area 4 of the property 2.

### List of reference signs

- 2: property to be secured
- 4: sub-area oft he property
- 6: security element
- 8: boundary line
- 10: entrance area
- 12: access control unit
- 14: geographical information data
- 16: digitally mapped processing surface
- 18: digital image of the security infrastructure
- 20: security protocol
- 22: implementation of the security infrastructure

- N: neural network

## Claims

1. A computer-implemented method for planning a security infrastructure for at least a sub-area (4) of a property (2) is described, the method comprising the steps of:
a) Providing geographical information data (14) about at least one sub-area (4) of the property (2);
b) Creating a digitally mapped processing surface (16) of the at least one sub-area (4) of the property (2) based on the geographical information data (14) provided in step a);
c) Selecting and arranging digital security elements (6) on the digitally mapped processing surface (16) to create a digital image (18) of the security infrastructure of the at least one sub-area (4) of the property (2);
d) Creating a security protocol (20) based on the digital image (18) of the security infrastructure created in step c), wherein the security protocol (20) comprises at least one piece of information about the number of security elements (6) and/or the type of security elements (6) and/or the position of the security elements (6) on the at least one sub-area (4) of the property (2).

2. Computer-implemented method according to claim 1, wherein the security protocol (20) created in step d) is used as a basis for the implementation (22) of the security infrastructure for the at least one sub-area (4) of the property (2).

3. Computer-implemented method according to claim 1 or 2, wherein the geographical information data (14) comprises at least one of the following information:
- Dimensions of the at least one sub-area (4) of the property (2); and/or
- Type of use of the at least one sub-area (4) of the property (2); and/or
- Special infrastructure on the at least one sub-area (4) of the property (2);

4. Computer-implemented method according to any one of the preceding claims, wherein the providing of the geographical information data (14) in step a) is carried out from one of the following information sources:
- Satellite images and/or satellite maps; and/or
- Road maps; and/or
- Drone images; and/or
- Technical drawings; and/or
- GIS-data.

5. Computer-implemented method according to any one of the preceeding claims, wherein wherein before or during step c), the following sub-steps are carried out:
- Calculating partial areas and/or the total area of the sub-area (4) of the property (2); and/or
- Calculating a three-dimensional terrain model and/or a three-dimensional building model of buildings located on the at least one sub-area (4) of the property (2); and/or
- Calculating the required lengths of the security elements (6), in particular fence lengths; and/or
- Calculating illuminated or illuminable areas of the at least one sub-area (4) of the property (2); and/or
- Calculating blind spots of surveillance cameras on the at least one sub-area (4) of the property (2).

6. Computer-implemented method according to any one of the preceding claims, wherein in step d), a risk analysis is additionally carried out to assess security vulnarabilities and/or hazards, wherein the result of the risk analysis is part of the security protocol (20).

7. Computer-implemented method according to claim 6, wherein the risk analysis is carried out based on predetermined security requirements and/or based on predetermined simulations of threat scenarios.

8. Computer-implemented method according to claim 6 or 7, wherein the risk analysis is additionally carried out with respect to the digital security elements selected and arranged in step c).

9. Computer-implemented method according to one of claims 6 to 8, wherein step c) is repeated if it is determined in the risk analysis carried out in step d) that the digital security elements (6) selected and arranged in step c) are insufficient, particularly if they contain security gaps and/or potential hazards.

10. Computer-implemented method according to any one of the preceding claims and claim 5, wherein a neural network (N) is used at least for step b) and/or step c) and/or step d) and/or for the sub-steps before or during step c).

11. Computer-implemented method according to claim 10, wherein step a) and/or step b) and/or step c) and/or step d) are sub-steps of creating a reference model for the machine learning of the neural network (N) to select the number and/or type and/or position of the digital security elements (6) on the at least one sub-area (4) of the property (2).

12. System for planning a security infrastructure for at least one sub-area (4) of a property (2), wherein the system comprises:
- A user interface module for performing steps a) and/or b) and/or c);
- An evaluation module for performing step d); and
- An output module for outputting the security protocol (20) created in step d).

13. System according to claim 12, wherein the system further comprises:
- A simulation module for simulating threat scenarios and/or security risks; and/or
- A conformity module for creating a security documentation, wherein the security documentation includes at least the security protocol (20).

14. Computer program product comprising instructions which, when the program is executed by a computer, cause the computer to carry out the method according to any one of claims 1 to 11.

15. Computer-readable storage medium comprising instructions which, when executed by a computer, cause the computer to carry out the method according to any one of claims 1 to 11.
